# EUROPÄISCHE PATENTANMELDUNG

(11) **EP 2 138 855 A1**
(43) Veröffentlichungstag der Anmeldung: **30.12.2009**
(21) Anmeldenummer: 08011722.9
(22) Anmeldetag: 27.06.2008
(51) Int. Cl.: G01R 31/04

(54) **Modulanordnungsdiagnose**

(71) Anmelder: Delphi Technologies, Inc., Troy, Michigan 48007 (US)
(72) Erfinder: Bäumer, Peter, 44789 Bochum (DE); Woeste, Guido, 58332 Schwelm (DE)
(74) Vertreter: Manitz, Finsterwald & Partner GbR

(57) **Zusammenfassung**

Die Erfindung betrifft ein elektrisches Koppelelement und ein Verfahren zum Koppeln zweier elektrischer Koppelelemente. An dem elektrischen Koppelelement ist eine Stirnseite mit zumindest zwei punktsymmetrisch angeordneten elektrischen Schnittstellen vorgesehen, um ein zweites elektrisches Koppelelement damit koppeln zu können. Da zur Kopplung zweier elektrischer Koppelelemente über die elektrischen Schnittstellen mindestens zwei Möglichkeiten bestehen, ist für das elektrische Koppelelement ein Mittel zur Erkennung der Ausrichtung des zweiten Koppelelements relativ zu dem Koppelelement vorgesehen, welches zu diesem Zweck eine der elektrischen Schnittstellen verwendet.

## Beschreibung

Die vorliegende Erfindung betrifft ein elektrisches Koppelelement zum Herstellen einer elektrischen Verbindung mit zumindest einem zweiten Koppelelement, wobei an dem Koppelelement eine Stirnseite mit mindestens zwei punktsymmetrisch angeordneten elektrischen Schnittstellen vorgesehen ist. Außerdem betrifft die Erfindung ein Verfahren zum Koppeln eines ersten elektrischen Koppelelements mit einem zweiten Koppelelement, welche jeweils eine Stirnseite und mindestens zwei punktsymmetrisch an der Stirnseite angeordnete elektrische Schnittstellen aufweisen.

Zur elektrischen Verbindung zweier elektrischer Koppelelemente oder Module ist eine Vielzahl von Schnittstellenkonzepten bekannt. Neben Stecker-Buchsen-Schnittstellen mit einer mechanischen Codierung, die in der Regel nur eine Kopplungsmöglichkeit zwischen zwei Elementen zulassen, und Stecker-Buchsen-Schnittstellen ohne eine mechanische Codierung, bei denen zwei oder mehr Kopplungsmöglichkeiten zulässig sind, zum Beispiel die deutsche Standard-Steckdose, gibt es auch Koppelelemente mit punktsymmetrischen und mechanisch identischen Schnittstellen.

Derartige Koppelelemente mit punktsymmetrischen und mechanisch identischen Schnittstellen können bei geeigneter mechanischer Ausgestaltung Vorteile beim Koppeln bzw. Zusammenfügen zweier Koppelelemente bieten, da sich ihre Schnittstellen aufgrund des Fehlens einer mechanischen Codierung und der mechanischen Einschränkungen bei Stecker-Buchsen-Systemen ohne vorherige Überprüfung der korrekten Ausrichtung zusammenfügen lassen. Diese Eigenschaft kann bei Installationen unter räumlich beengten Bedingungen und teilweise fehlender Sicht auf die Koppelstelle, zum Beispiel bei der Kraftfahrzeugmontage, von Vorteil sein.

Ein weiterer Vorteil derartiger Koppelelemente wird offensichtlich, wenn mehrere Koppelelemente miteinander gekoppelt werden sollen. In diesem Fall ist es nicht notwendig, für jedes Modul Ausprägungen mit unterschiedlichen Buchsen/ Steckerkombinationen vorzuhalten, da eine einzige Ausprägungsform für jedes Modul aufgrund dieser Schnittstelle ausreicht.

Eine mögliche mechanische Ausgestaltung derartiger Schnittstellen und Koppelelemente ist zum Beispiel in der ebenfalls anhängigen europäischen Patentanmeldung EP 08 001 076 mit dem Titel "Koppelelement", die am 21. Januar 2008 eingereicht wurde, offenbart, deren Offenbarung durch Bezugnahme hierin vollständig mitaufgenommen und mitumfasst ist.

Da bei Koppelelementen der zuletzt genannten Art eine Unterteilung derselben in Stecker und Buchse bzw. männlich und weiblich nicht stattfindet und jedes Koppelelement aufgrund des punktsymmetrischen Aufbaus mit einem weiteren Koppelelement mit mindestens zwei verschiedenen Ausrichtungen kombiniert werden kann, ist es jedoch erforderlich, festzustellen, auf welche Weise zwei Koppelelemente kombiniert werden, damit eine korrekte Zuordnung und Verwendung von elektrischen Signalen an dessen Schnittstellen erfolgen kann.

Es ist daher die Aufgabe der Erfindung, ein elektrisches Koppelelement und ein Verfahren bereitzustellen, die eine kostengünstige und effektive Kopplungserkennung bereitstellen.

Diese Aufgabe wird durch die Merkmale der unabhängigen Ansprüche gelöst.

Gemäß Anspruch 1 wird ein elektrisches Koppelelement zum Herstellen einer elektrischen Verbindung mit zumindest einem zweiten Koppelelement bereitgestellt, wobei an dem Koppelelement eine Stirnseite mit mindestens zwei punktsymmetrisch angeordneten elektrischen Schnittstellen vorgesehen ist. Für das Koppelelement ist erfindungsgemäß ein Mittel vorgesehen, welches speziell eingerichtet ist, um die Ausrichtung des zweiten Koppelelements beim Herstellen einer elektrischen Verbindung mit dem Koppelelement über eine der elektrischen Schnittstellen zu erkennen.

Mit anderen Worten weist das erfindungsgemäße Koppelelement also mindestens zwei punktsymmetrisch angeordnete elektrische Schnittstellen auf und ermöglicht somit eine Kopplung mit einem zweiten Koppelelement in mindestens zwei verschiedenen Anordnungskonstellationen, welche im Kontext dieser Erfindung als Ausrichtungen des zweiten Koppelelements relativ zu dem ersten Koppelelement bezeichnet werden. Das Mittel zur Erkennung der Ausrichtung verwendet dabei nur eine einzige der elektrischen Schnittstellen des Koppelelements, um die Ausrichtung des zweiten Koppelelements zu erkennen, wodurch die Erkennung einfach und effektiv ausgeführt werden kann.

Um die Erkennung der Ausrichtung zu ermöglichen, kann bei einer bevorzugten Ausführungsform für jede elektrische Schnittstelle des Koppelelements ein Identifikationsmittel vorgesehen sein, welches speziell eingerichtet ist, um die zugehörige elektrische Schnittstelle innerhalb des Koppelelements eindeutig zu identifizieren. Jede der punktsymmetrischen elektrischen Schnittstellen kann dabei ein eigenes Identifikationsmittel aufweisen, das eine innerhalb des Koppelelements eindeutige Identifikation der jeweiligen elektrischen Schnittstelle ermöglicht. Da bei allen Koppelelementen die elektrischen Schnittstellen mit ihren jeweiligen Identifikationsmitteln relativ zueinander gleich angeordnet sind, kann das Mittel zur Erkennung der Ausrichtung aus der Kenntnis der Lage einer elektrischen Schnittstelle des zweiten Koppelelements relativ zu dem Koppelelement auf die Ausrichtung des zweiten Koppelelements schließen.

Das Identifikationsmittel der elektrischen Schnittstellen kann bei einer Ausführungsform so eingerichtet sein, dass es die elektrische Schnittstelle auf analoge Weise über Spannungspegel identifiziert. Mit anderen Worten liefert bei dieser Ausführungsform jede elektrische Schnittstelle des Koppelelements zur Identifikation einen Spannungswert, der sich von den Spannungswerten aller anderen elektrischen Schnittstellen des Koppelelements unterscheidet, so dass jede elektrische Schnittstelle anhand des von ihr gelieferten Spannungswerts innerhalb des Koppelelements eindeutig erkennbar ist. Bei dieser Ausführungsform verfügt das Mittel zur Erkennung der Ausrichtung über die Fähigkeit, verschiedene Spannungspegel zu unterscheiden, beispielsweise über einen oder mehrere Komparatoren oder einen Prozessor mit integriertem A/D-Wandler usw. Alternativ wäre es auch möglich, anstelle von unterschiedlichen Spannungspegeln mit unterschiedlichen Strompegeln oder Widerstandswerten zu arbeiten, um eine Identifikation auf analoge Weise zu erreichen.

Eine alternative Ausführungsform sieht vor, dass das Identifikationsmittel so eingerichtet ist, dass es die elektrische Schnittstelle auf digitale Weise über die Zeitdauer von Impulsen identifiziert. Bei dieser Ausführungsform liefert jede elektrische Schnittstelle des Koppelelements zur Identifikation einen Impuls mit einer definierten vorbestimmten Zeitdauer, die sich von den Zeitdauern der Impulse aller anderen elektrischen Schnittstellen des Koppelelements unterscheidet, so dass jede elektrische Schnittstelle anhand der Zeitdauer des Impulses innerhalb des Koppelelements eindeutig erkennbar ist. In diesem Fall verfügt das Mittel zur Erkennung der Ausrichtung über die Fähigkeit, verschiedene Zeitdauern zu erfassen und auszuwerten, was beispielsweise unter Verwendung eines Taktgenerators und eines Zählers und/oder eines Mikroprozessors möglich ist.

Eine weitere alternative Ausführungsform des Identifikationsmittels der elektrischen Schnittstelle sieht vor, dass das Identifikationsmittel so eingerichtet ist, dass es die elektrische Schnittstelle mit einem Busübertragungsprotokoll über Dateneinheiten wie beispielsweise Bits in einem Datenbustelegramm identifiziert. Dabei kann das Identifikationsmittel jeder elektrischen Schnittstelle des Koppelelements so ausgestaltet sein, dass es auf eine Anforderung, die beispielsweise über ein Datenbustelegramm des Busübertragungsprotokolls erfolgen kann, mit einem weiteren Datenbustelegramm des Busübertragungsprotokoll antwortet, in dem ein oder mehrere Dateneinheiten wie beispielsweise Bits die Identifikation der jeweiligen elektrischen Schnittstelle enthalten. Bei zwei elektrischen Schnittstellen je Koppelelement genügt dabei ein Bit, bei vier elektrischen Schnittstellen je Koppelelement werden zwei Bit benötigt, bei bis zu acht elektrischen Schnittstellen je Koppelelement sind drei Bit nötig, usw. Das Mittel zur Erkennung der Ausrichtung des zweiten Koppelelements weist bei dieser Ausführungsform die Fähigkeit auf, ein Datenbustelegramm des Busübertragungsprotokolls zu senden, zu empfangen und auszuwerten, was zum Beispiel unter Verwendung eines Mikroprozessors erfolgen kann. Da diese Ausführungsform bereits zur Identifikation ein Busübertragungsprotokoll verwendet, können die Koppelelemente vorzugsweise zur Kopplung eines Busses ausgebildet sein.

Das Mittel, welches speziell eingerichtet ist, um die Ausrichtung des zweiten Koppelelements beim Herstellen einer elektrischen Verbindung mit dem Koppelelement über eine der elektrischen Schnittstellen zu erkennen, kann gemäß einer bevorzugten Ausführungsform ferner so eingerichtet sein, dass es mindestens einen Konfigurationsbefehl zur Konfiguration des zweiten Koppelelements an dieses senden kann. In diesem Fall verfügt dieses Mittel über zusätzliche "Intelligenz" bzw. eine Art "Master-Funktionalität", um das zweite Koppelelement, das bei dieser Ausführungsform über eine Art "Slave-Funktionalität" verfügt, zu konfigurieren. Eine Konfiguration des zweiten Koppelelements kann dabei beispielsweise das Zuweisen einer Modul/Element-Adresse, das Zuweisen von Parametern etc. umfassen.

Bei einer weiteren Ausführungsform kann das Mittel, welches eingerichtet ist, um die Ausrichtung des zweiten Koppelelements beim Herstellen einer elektrischen Verbindung mit dem Koppelelement über eine der elektrischen Schnittstellen zu erkennen, ferner eingerichtet sein, um eine Schnittstelle eines dritten Koppelelements bei einer Kopplung mit dem zweiten Koppelelement abzufragen und dieses dritte Koppelelement ggf. zu konfigurieren. Diese Funktionalität ermöglicht es dem Erkennungsmittel, über das zweite Koppelelement auf das dritte zuzugreifen und schafft somit die Möglichkeit, sukzessive eine Koppelelementkette herzustellen und ggf. zu konfigurieren, um beispielsweise eine Busverbindung in einem Kraftfahrzeug aufzubauen.

Eine besonders bevorzugte Ausführungsform sieht an dem Koppelelement zwei Stirnseiten mit jeweils mindestens zwei punktsymmetrisch angeordneten elektrischen Schnittstellen vor. Koppelelemente dieser Art bieten bei der Montage weitere Möglichkeiten bzw. Freiheitsgrade und können leicht zu einer Koppelelementkette gekoppelt werden. Gleichzeitig ist die Anzahl der Kombinationsmöglichkeiten zweier derartiger Koppelelemente noch gut verwaltbar, da jede Stirnseite des ersten Koppelelements auf jeweils vier Arten mit den Stirnseiten des zweiten Koppelelements kombinierbar ist, es insgesamt also acht Kombinationsmöglichkeiten oder Ausrichtungen zweier Koppelelemente zueinander gibt.

Im Folgenden wird nun genauer auf das erfindungsgemäße Verfahren zum Koppeln eines ersten elektrischen Koppelelements mit einem zweiten Koppelelement eingegangen. Der Vollständigkeit halber sei an dieser Stelle erwähnt, dass sämtliche verfahrensartigen Aspekte und Merkmale, welche zuvor unter Bezugnahme auf das erfindungsgemäße Koppelelement beschrieben wurden, in analoger Weise auf das erfindungsgemäße Verfahren übertragen werden können.

Bei dem erfindungsgemäßen Verfahren zum Koppeln eines ersten elektrischen Koppelelements mit einem zweiten Koppelelement, welche jeweils eine Stirnseite und mindestens zwei punktsymmetrisch an der Stirnseite angeordnete elektrische Schnittstellen aufweisen, wird zunächst eine elektrische Verbindung des ersten Koppelelements mit dem zweiten Koppelelement hergestellt, bevor anschließend eine Identifikation einer elektrischen Schnittstelle des zweiten Koppelelements über eine elektrische Schnittstelle des ersten Koppelelements abgefragt wird. Anschließend wird die Identifikation der abgefragten Schnittstelle des zweiten Koppelelements über die elektrische Schnittstelle des ersten Koppelelements empfangen.

Bei dem erfindungsgemäßen Verfahren werden also zunächst zwei Koppelelemente an ihren jeweiligen Stirnseiten verbunden, so dass die dort angeordneten elektrischen Schnittstellen paarweise kontaktiert sind. Um zu erkennen, wie die beiden Koppelelemente relativ zueinander ausgerichtet sind, wird eine der elektrischen Schnittstellen des ersten Koppelelements verwendet, um die damit verbundene elektrische Schnittstelle des zweiten Koppelelements abzufragen. Daraufhin übermittelt die abgefragte elektrische Schnittstelle des zweiten Koppelelements ihre Identifikation über die damit verbundene elektrische Schnittstelle des ersten Koppelelements, wo diese empfangen wird.

Bei einer bevorzugten Ausführungsform des Verfahrens kann die Ausrichtung des zweiten Koppelelements relativ zu dem ersten Koppelelement aus der empfangenen Identifikation der abgefragten Schnittstelle des zweiten Koppelelements ermittelt werden. Dies ist möglich, weil die Anordnung der elektrischen Schnittstellen der Koppelelemente bei allen Koppelelementen gleich ist und somit die Kenntnis der Identität einer elektrischen Schnittstelle zur Erkennung der Ausrichtung des zweiten Koppelelements relativ zu dem ersten Koppelelement ausreicht. Dieses Verfahren ermöglicht somit ein einfaches, kostengünstiges Erkennen der Ausrichtung der beiden Koppelelemente zueinander.

Das Abfragen der Identifikation einer elektrischen Schnittstelle des zweiten Koppelelements kann bei unterschiedlichen Ausführungsformen auf analoge Weise über Spannungspegel, auf digitale Weise über die vordefinierte Zeitdauer von Impulsen oder mit einem Busübertragungsprotokoll über Dateneinheiten wie beispielsweise Bits in einem Datenbustelegramm erfolgen. Mit diesen Ausführungsformen kann die Identifikation je nach Anwendungsfall an die jeweiligen Erfordernisse angepasst werden.

Bei einer weiteren Ausführungsform des Verfahrens kann zumindest ein Konfigurationsbefehl über eine elektrische Schnittstelle an das zweite Koppelelement gesendet werden, sodass dieses konfiguriert wird. Diese Ausführungsform ermöglicht es dem ersten Koppelelement, das zweite Koppelelement nach der Erkennung der Ausrichtung zu konfigurieren, um das zweite Koppelelement auf die gewünschte Funktionalität einzustellen.

Die Abfrage der Identifikation einer elektrischen Schnittstelle eines dritten Koppelelements, wenn dieses mit dem zweiten Koppelelement, welches bereits mit dem ersten Koppelelement gekoppelt ist, gekoppelt wird, über eine elektrische Schnittstelle des zweiten Koppelelements kann bei einer weiteren Ausführungsform vorgesehen sein. Zudem sieht diese Ausführungsform das Empfangen der Identifikation der abgefragten Schnittstelle des dritten Koppelelements über die elektrische Schnittstelle des zweiten Koppelelements vor. Diese Ausführungsform des Verfahrens ermöglicht somit den Durchgriff von dem ersten Koppelelement über das zweite Koppelelement auf das dritte Koppelelement und bildet damit die Grundlage für den Aufbau einer Koppelelementkette.

Bei einer weiteren Ausführungsform ist zudem das Senden zumindest eines Konfigurationsbefehls über die elektrische Schnittstelle des zweiten Koppelelements an das dritte Koppelelement vorgesehen, wodurch dieses konfiguriert wird. Diese Ausführungsform ist vorteilhaft, wenn die Koppelelemente zum Aufbau eines Busses verwendet werden.

Nachstehend wird eine bevorzugte Ausführungsform der Erfindung unter Bezugnahme auf die beiliegenden Figuren erläutert, in denen
- Fig. 1: eine schematische Darstellung eines Koppelelements gemäß einer bevorzugten Ausführungsform der Erfindung ist;
- Fig. 2: eine schematische Darstellung der elektrischen Kopplung zweier Koppelelemente gemäß einer bevorzugten Ausführungsform der Erfindung ist;
- Fig. 3A: ein Prinzipschaltbild einer analogen Identifikationsschaltung einer elektrischen Schnittstelle des Koppelelements von Fig. 1 ist;
- Fig. 3B: ein Prinzipschaltbild einer digitalen Identifikationsschaltung einer elektrischen Schnittstelle des Koppelelements von Fig. 1 ist;
- Fig. 4: eine schematische Darstellung der Kombinationsmöglichkeiten der zwei Koppelelemente von Fig. 2 ist; und
- Fig. 5: eine schematische Darstellung der Kopplung eines dritten Kopplungselements an zwei gekoppelte Koppelelemente ist.

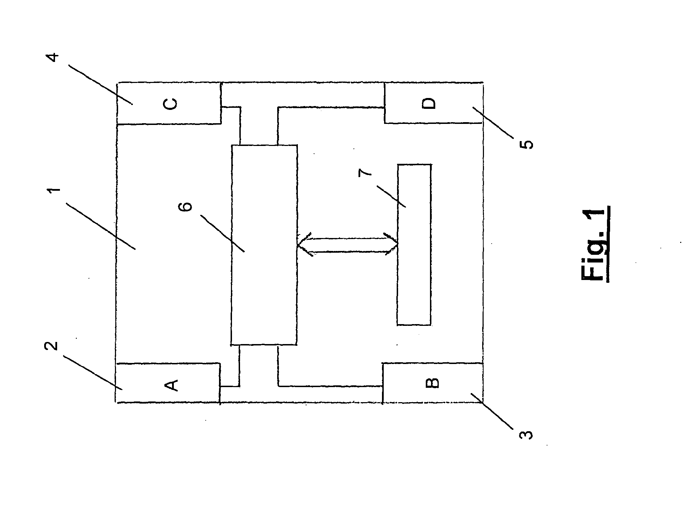

Das in Fig. 1 gezeigte Koppelelement 1 einer bevorzugten Ausführungsform der Erfindung weist vier gleichartige elektrische Schnittstellen 2, 3, 4, 5 auf. Jede der elektrischen Schnittstellen 2, 3, 4, 5 umfasst mindestens eine elektrische Kontaktfläche zur Übertragung von Signalen und/oder Energie. Die elektrischen Schnittstellen 2, 3, 4, 5 sind zudem mit einem Identifikationsmittel in Form des Positionsidentifikationsmoduls 6 elektrisch verbunden, das wiederum mit einer Datenschnittstelle 7 gekoppelt ist.

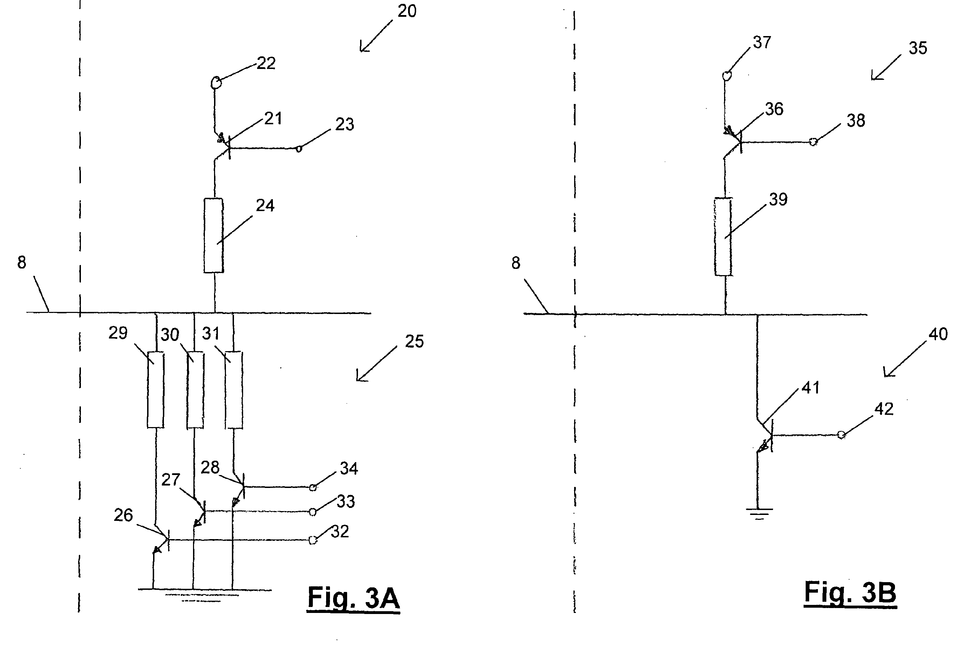

Das Positionsidentifikationsmodul 6 dient zur Identifikation der damit verbundenen elektrischen Schnittstellen 2, 3, 4, 5, wenn eine davon bei einer Kopplung mit einem weiteren Koppelelement abgefragt wird. Zur Bereitstellung der benötigten Identifikationsinformationen kann das Positionsidentifikationsmodul 6 beispielsweise eine der in Fig. 3A oder 3B dargestellten analogen oder digitalen Identifikationsschaltungen umfassen. Alternativ oder zusätzlich kann das Positionsidentifikationsmodul 6 eine anwenderspezifische integrierte Schaltung (ASIC, CPLD, FPGA etc.), einen Mikroprozessor mit einem Speicher zur Ausführung eines oder mehrerer Programme, eine Logikschaltung oder ähnliches umfassen, um eine beliebige zusätzliche Funktionalität des Koppelelements bereitzustellen, welche für den Umfang dieser Erfindung von geringerer Bedeutung ist.

Neben der Bereitstellung der benötigten Identifikationsinformationen kann das Positionsidentifikationsmodul 6 auch die Fähigkeit zum Abfragen einer elektrischen Schnittstelle bei einer Kopplung mit einem weiteren Koppelelement aufweisen. Über die Verbindung zu der Datenschnittstelle 7 kann das Positionsidentifikationsmodul 6 die erfragten Identifikationsdaten an ein nicht dargestelltes Modul zur Erkennung der Ausrichtung des zweiten Koppelelements weiterleiten. Alternativ kann die Erkennung der Ausrichtung auch im Positionsidentifikationsmodul 6 selbst durchgeführt werden und nur das Ergebnis an die Datenschnittstelle 7 weitergeleitet werden.

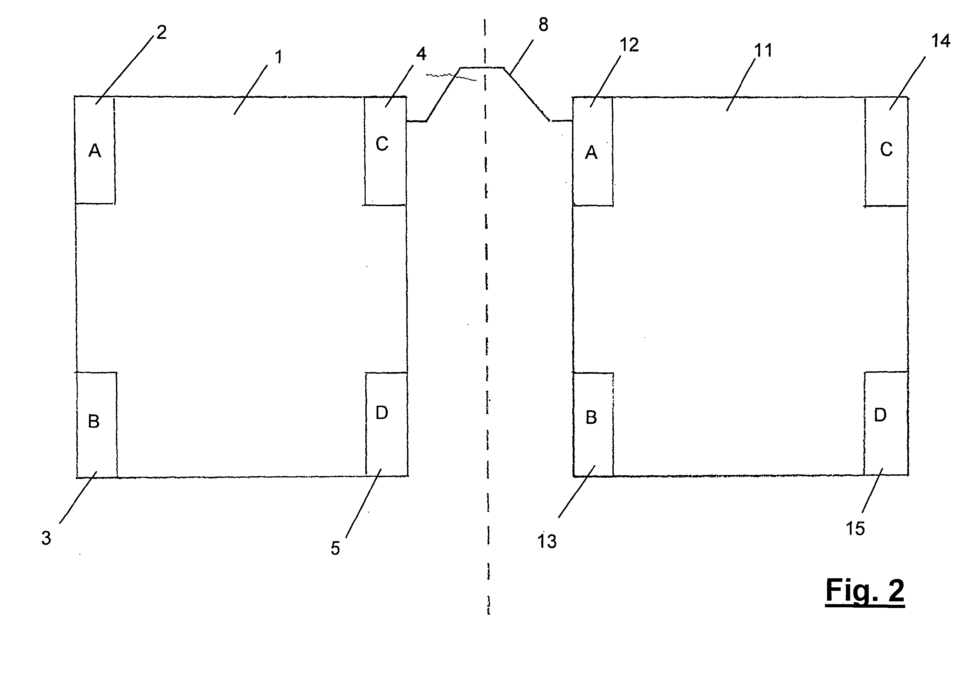

Fig. 2 veranschaulicht schematisch, wie die Erkennung der Ausrichtung eines zweiten Koppelelements 11 relativ zu dem ersten Koppelelement 1 ablaufen kann. Eine der elektrischen Schnittstellen des ersten Koppelelements 1, in dem dargestellten Beispiel die Schnittstelle 4, wird verwendet, um eine Identifikation der mit dieser über die Verbindung 8 in Kontakt stehenden Schnittstelle 12 des zweiten Koppelelements 11 zu erfragen. Zu diesem Zweck wird von dem Mittel zur Erkennung der Ausrichtung des ersten Koppelelements 1 ein Abfragesignal erzeugt und über die elektrische Schnittstelle 4 und die Verbindung 8 an die elektrische Schnittstelle 12 des zweiten Koppelelements 11 übertragen. Daraufhin erzeugt das Identifikationsmittel des zweiten Koppelelements 11 ein entsprechendes Identifikationssignal und überträgt es über die elektrische Schnittstelle 12 und die Verbindung 8 an die elektrische Schnittstelle 4 des ersten Koppelelements 1 zurück, woraufhin das Mittel zur Erkennung der Ausrichtung daraus die Ausrichtung des zweiten Koppelelements 11 relativ zu dem ersten Koppelelement 1 ermittelt. Nachstehend wird dieser Ablauf anhand von Fig. 3A und 3B genauer erörtert.

Fig. 3A zeigt eine Beispielschaltung zur analogen Identifikation einer elektrischen Schnittstelle. Dabei stellt die obere Hälfte eine Anforderungsschaltung 20 dar, die z.B. in Fig. 2 im ersten Koppelelement 1 verwendet werden kann, um ein Anforderungssignal über die Verbindung 8 an die elektrische Schnittstelle 12 des zweiten Koppelelements 11 zu senden. Die Anforderungsschaltung 20 umfasst hier einen pnp-Transistor 21, dessen Emitter mit einer Spannungsquelle, beispielsweise einer positiven Referenzspannung 22 verbunden ist. Durch das Anlegen einer geeigneten Spannung an die Basis 23 des pnp-Transistors 21 schaltet dieser die Referenzspannung 22 an den Widerstand 24, wodurch das Potential der Verbindung 8 zu positiven Werten hin verschoben wird. Somit wird durch das Schalten von Transistor 21 ein Spannungsanstiegssignal bzw. eine positive Flanke von der elektrischen Schnittstelle 4 des ersten Koppelelements 1 an die elektrische Schnittstelle 12 des zweiten Koppelelements 11 übertragen.

Die in der unteren Hälfte von Fig. 3A dargestellte Identifikationsschaltung 25 weist hier drei npn-Transistoren 26, 27, 28 auf, deren Emitter jeweils mit Masse verbunden sind, während deren Kollektoren über Widerstände 29, 30, 31 mit der Kontaktfläche der elektrischen Schnittstelle 12 bzw. der Verbindung 8 verbunden sind. Wenn an einen oder mehrere der Basiskontakte 32, 33, 34 der Transistoren 26, 27, 28 eine geeignete Spannung angelegt wird, dann schalten die entsprechenden Transistoren und verbinden die zugehörigen Widerstände 29, 30 bzw. 31 mit Masse. Durch diese Verbindung(en) wird das an der Verbindung 8 anliegende Potential zu Masse hin verschoben. Durch eine geeignete Wahl der Werte für die Widerstände 24 und 29, 30, 31 können an der Verbindung 8 Spannungspegel erzeugt werden, die beim Durchschalten des Transistors 28 durch Anlegen einer geeigneten Spannung am Basiskontakt 34 beispielsweise etwa 2/3 der Referenzspannung 22, beim Durchschalten des Transistors 27 durch Anlegen einer geeigneten Spannung am Basiskontakt 33 beispielsweise etwa 1/3 der Referenzspannung 22 und beim Durchschalten des Transistors 26 durch Anlegen einer geeigneten Spannung am Basiskontakt 32 beispielsweise etwa Null Volt betragen können, womit drei der vier elektrischen Schnittstellen eines Koppelelements identifiziert werden können. Zur Identifikation der vierten elektrischen Schnittstelle kann beispielsweise eine Parallelschaltung der Widerstände 30 und 31 durch ein gleichzeitiges Durchschalten der Transistoren 27 und 28 verwendet werden.

Wenn die Identifikation der elektrischen Schnittstelle auf digitale Weise erfolgen soll, dann kann die in Fig. 3B gezeigte Schaltung verwendet werden. Die in der oberen Hälfte gezeigte digitale Anforderungsschaltung 35 ist prinzipiell identisch wie die analoge Anforderungsschaltung 25 aufgebaut und umfasst hier einen pnp-Transistor 36, dessen Emitter mit einer Spannungsquelle, beispielsweise einer positiven Referenzspannung 37 verbunden ist. Durch das Anlegen einer geeigneten Spannung an die Basis 38 des pnp-Transistors 36 schaltet dieser die Referenzspannung 37 an den Widerstand 39, wodurch das Potential der Verbindung 8 zu positiven Werten hin verschoben wird. Somit wird durch das Schalten von Transistor 36 ein Spannungsanstiegssignal bzw. eine positive Flanke übertragen.

Die in der unteren Hälfte von Fig. 3B gezeigte digitale Identifikationsschaltung 40 reagiert auf die durch die voranstehend beschriebene Identifikationsanforderung, die durch die positive Flanke dargestellt ist, indem hier der npn-Transistor 41 durch Anlegen einer geeigneten Spannung an den Basisanschluss 42 des Transistors 41 durchgeschaltet und damit das Potential der Verbindung 8 auf Masse "gezogen" wird.

Die Anforderungsschaltung 35 und die Identifikationsschaltung 40 können zur Identifikation auf zwei verschiedene Arten verwendet werden. Bei der ersten, in diesem Kontext als "digital" bezeichneten Technik reagiert die Identifikationsschaltung 40 auf die beschriebene positive Flanke dadurch, dass an den Basisanschluss 42 des Transistors 41 eine geeignete Spannung, die den Transistor 41 durchschaltet, für eine vordefinierte Zeitspanne angelegt wird. Für die vordefinierte Zeitspanne, die für jede der vier elektrischen Schnittstellen jedes Koppelelements unterschiedlich lang ist, wird folglich durch die Identifikationsschaltung 40 das Potential an der Verbindung 8 zu Masse hin verschoben. Diese Potentialverschiebung sowie die Dauer derselben werden von der elektrischen Schnittstelle 4 des ersten Koppelelements 1, über welche das Anforderungssignal bzw. die positive Flanke übertragen wurde, aufgenommen und daraus die Ausrichtung des zweiten Koppelelements 11 relativ zum ersten Koppelelement 1 ermittelt.

Bei der zweiten Art, die in diesem Kontext als "Busübertragungsprotokoll" bezeichnet wird, werden sowohl die Anforderungsschaltung 35 als auch die Identifikationsschaltung 40 zur Übertragung von Spannungsimpulsen mit gleicher Zeitdauer verwendet, wobei jeder dieser Spannungsimpulse einem Bit in einem Datenbustelegramm des Busübertragungsprotokolls entspricht. Bei dieser Variante wird zunächst über die elektrische Schnittstelle 4 des ersten Koppelelements 1 und die Verbindung 8 eine Folge derartiger Impulse an das zweite Koppelelement 11 übertragen. Diese Impulsfolge entspricht einem Datenbustelegramm, das eine Identifikationsaufforderung enthält. Daraufhin überträgt das zweite Koppelelement 11 über die elektrische Schnittstelle 12 eine Impulsfolge, die einem Identifikations-Datenbustelegramm entspricht. Einige Impulse bzw. Bits dieses Datenbustelegramms enthalten die eigentliche Identifikationsinformation der abgefragten elektrischen Schnittstelle 12 des zweiten Koppelelements 11. Bei der dargestellten Ausführungsform genügen zwei Bits, um die vier elektrischen Schnittstellen des Koppelelements zu identifizieren.

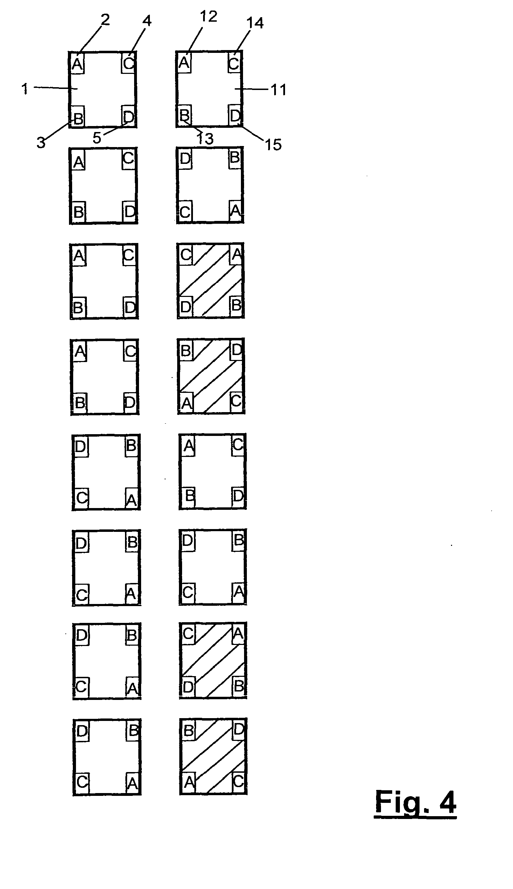

In Fig. 4 sind die insgesamt acht Kombinationsmöglichkeiten der beiden Koppelelemente 1 und 11 der beispielhaften Ausführungsform in einer Matrix mit acht Zeilen und zwei Spalten veranschaulicht. In der linken Spalte ist das erste Koppelelement 1 dargestellt, wobei das Koppelelement 1 bei den ersten vier Zeilen so angeordnet ist, dass die elektrischen Schnittstellen 4 und 5 zur Kopplung mit dem zweiten Koppelelement 11 gelangen, und in den restlichen vier Zeilen um 180 Grad gedreht angeordnet ist, so dass die elektrischen Schnittstellen 2 und 3 zur Kopplung mit dem zweiten Koppelelement 11 gelangen. Das zweite Koppelelement 11 ist zwischen der ersten und zweiten, dritten und vierten, fünften und sechsten und siebten und achten Zeile jeweils um 180 Grad gedreht. Zwischen der zweiten und dritten, vierten und fünften und sechsten und siebten Zeile wurde das zweite Koppelelement 11 jeweils umgedreht, so dass teilweise die schraffiert dargestellte Rückseite des Koppelelements 11 dargestellt ist.

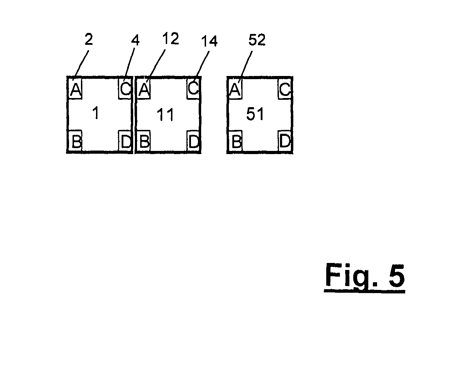

Anhand von Fig. 5 wird nun die Fähigkeit der Koppelelemente der beispielhaften Ausführungsform zum Aufbau einer Koppelelementkette veranschaulicht. In Fig. 5 sind die aus Fig. 2 bekannten Koppelelemente 1 und 11 bereits miteinander gekoppelt, wobei in diesem Beispiel das Koppelelement 1 als "Master" arbeitet und das Koppelelement 11 identifiziert und konfiguriert hat. Je nach Ausgestaltung der individuellen Koppelelemente kann selbstverständlich auch das Koppelelement 11 über die Masterfunktionalität verfügen und das Koppelelement 1 konfigurieren.

In diesem Beispiel ist das Koppelelement 1 eine ECU eines Kraftfahrzeugs und das Koppelelement 11 ein Sensormodul zur Erfassung eines Sensorsignals. Das Koppelelement 1 hat dem Koppelelement 11 eine interne Busadresse zugewiesen, und verschiedene Parameter konfiguriert, wie zum Beispiel die Auflösung, mit welcher das Koppelmodul 11 das Sensorsignal digitalisieren und übertragen soll. Zur Identifikation wurde dabei, wie beispielsweise in Fig. 2 und Fig. 3A und 3B beschrieben, die Schnittstelle 4 von Koppelelement 1 und die Schnittstelle 12 von Koppelelement 11 verwendet.

Nun wird ein drittes Koppelelement 51 an die noch freie Stirnseite des zweiten Koppelelements 11 angekoppelt, um beispielsweise einen weiteren Sensor mit der durch das Koppelelement 1 gebildeten ECU zu verbinden. Das Koppelelement mit der Masterfunktion, im Beispiel also das Koppelelement 1, sendet zu diesem Zweck ein Identifikationsaufforderungstelegramm über seine Schnittstelle 4, das über die Schnittstellen 12 und 14 des zweiten Koppelelements 11 zu der Schnittstelle 52 des dritten Koppelelements 51 gelangt. Dieses Versenden kann von dem Masterelement periodisch ausgeführt werden, um zusätzliche Koppelelemente jederzeit erkennen und in die Kette aufnehmen zu können. Alternativ kann ein derartiges Versenden von Identifikationsaufforderungstelegrammen auf eine Initialisierungsphase des elektrischen Systems beschränkt sein und abgebrochen werden, sobald sich kein weiteres Koppelelement mehr meldet.

Das dritte Koppelelement 51 identifiziert sich, indem es seine elektrische Schnittstelle 52 auf die in Verbindung mit Fig. 3B beschriebene Weise durch Übertragung eines Datenbustelegramms des Busübertragungsprotokolls identifiziert. Dieses Telegramm gelangt über die Schnittstellen 14 und 12 des zweiten Koppelelements 11 zu der Schnittstelle 4 des ersten Koppelelements 1 und wird dort ausgewertet. Das Koppelelement 1 sendet nach der Auswertung ein oder mehrere Datenbustelegramme über das zweite Koppelelement 11 an das dritte Koppelelement 51, um diesem beispielsweise eine interne Busadresse zuzuweisen und es anderweitig zu konfigurieren. Dieser Vorgang wird sukzessive wiederholt, bis alle miteinander gekoppelten Koppelelemente identifiziert und ggf. konfiguriert wurden.

### Bezugszeichenliste

- 1: erstes Koppelelement
- 2, 3, 4, 5: elektrische Schnittstellen von 1
- 6: Positionsidentifikationsmodul
- 7: Datenschnittstelle
- 8: Verbindung zweier elektrischer Schnittstellen
- 11: zweites Koppelelement
- 12, 13, 14, 15: elektrische Schnittstellen von 11
- 20: analoge Anforderungsschaltung
- 21: pnp-Transistor
- 22: Referenzspannung
- 23: Basis von 21
- 24: Widerstand
- 25: analoge Identifikationsschaltung
- 26, 27, 28: npn-Transistor
- 29, 30, 31: Widerstand
- 32, 33, 34: Basiskontakte von 26, 27, 28
- 35: digitale Anforderungsschaltung
- 36: pnp-Transistor
- 37: Referenzspannung
- 38: Basis von 36
- 39: Widerstand
- 40: digitale Identifikationsschaltung
- 41: npn-Transistor
- 42: Basis von Transistor 41
- 51: drittes Koppelelement
- 52: elektrische Schnittstelle von 51

## Patentansprüche

1. Elektrisches Koppelelement zum Herstellen einer elektrischen Verbindung mit zumindest einem zweiten Koppelelement, wobei an dem Koppelelement eine Stirnseite mit mindestens zwei punktsymmetrisch angeordneten elektrischen Schnittstellen vorgesehen ist,
**dadurch gekennzeichnet, dass**
für das Koppelelement ein Mittel vorgesehen ist, welches eingerichtet ist, um die Ausrichtung des zweiten Koppelelements beim Herstellen einer elektrischen Verbindung mit dem Koppelelement über eine der elektrischen Schnittstellen zu erkennen.

2. Koppelelement nach Anspruch 1,
**dadurch gekennzeichnet, dass**
für jede elektrische Schnittstelle des Koppelelements ein Identifikationsmittel vorgesehen ist, welches eingerichtet ist, um die zugehörige elektrische Schnittstelle innerhalb des Koppelelements eindeutig zu identifizieren.

3. Koppelelement nach Anspruch 2,
**dadurch gekennzeichnet, dass**
das Identifikationsmittel eingerichtet ist, um die elektrische Schnittstelle auf analoge Weise über Spannungspegel zu identifizieren.

4. Koppelelement nach Anspruch 2,
**dadurch gekennzeichnet, dass**
das Identifikationsmittel eingerichtet ist, um die elektrische Schnittstelle auf digitale Weise über die Zeitdauer von Impulsen zu identifizieren.

5. Koppelelement nach Anspruch 2,
**dadurch gekennzeichnet, dass**
das Identifikationsmittel eingerichtet ist, um die elektrische Schnittstelle mit einem Busübertragungsprotokoll über Dateneinheiten in einem Datenbustelegramm zu identifizieren.

6. Koppelelement nach mindestens einem der vorherigen Ansprüche,
**dadurch gekennzeichnet, dass**
das Mittel, welches eingerichtet ist, um die Ausrichtung des weiteren Koppelelements beim Herstellen einer elektrischen Verbindung mit dem Koppelelement über eine der elektrischen Schnittstellen zu erkennen, ferner eingerichtet ist, um mindestens einen Konfigurationsbefehl zur Konfiguration des zweiten Koppelelements an dieses zu senden.

7. Koppelelement nach mindestens einem der vorherigen Ansprüche,
**dadurch gekennzeichnet, dass**
das Mittel, welches eingerichtet ist, um die Ausrichtung des weiteren Koppelelements beim Herstellen einer elektrischen Verbindung mit dem Koppelelement über eine der elektrischen Schnittstellen zu erkennen, ferner eingerichtet ist, um eine Schnittstelle eines dritten Koppelelements bei einer Kopplung mit dem zweiten Koppelelement abzufragen und dieses ggf. zu konfigurieren.

8. Koppelelement nach mindestens einem der vorherigen Ansprüche,
**dadurch gekennzeichnet, dass** an dem Koppelelement zwei Stirnseiten mit jeweils mindestens zwei punktsymmetrisch angeordneten elektrischen Schnittstellen vorgesehen sind.

9. Verfahren zum Koppeln eines ersten elektrischen Koppelelements mit einem zweiten Koppelelement, welche jeweils eine Stirnseite und mindestens zwei punktsymmetrisch an der Stirnseite angeordnete elektrische Schnittstellen aufweisen, mit den Schritten:
elektrisches Verbinden des ersten Koppelelements mit dem zweiten Koppelelement;
Abfragen einer Identifikation einer elektrischen Schnittstelle des zweiten Koppelelements über eine elektrische Schnittstelle des ersten Koppelelements; und
Empfangen der Identifikation der abgefragten Schnittstelle des zweiten Koppelelements über die elektrische Schnittstelle des ersten Koppelelements.

10. Verfahren nach Anspruch 9,
ferner **gekennzeichnet durch** den Schritt:
Ermitteln der Ausrichtung des zweiten Koppelelements relativ zu dem ersten Koppelelement aus der empfangenen Identifikation der abgefragten Schnittstelle des zweiten Koppelelements.

11. Verfahren nach Anspruch 9,
**dadurch gekennzeichnet, dass**
das Abfragen der Identifikation einer elektrischen Schnittstelle des zweiten Koppelelements auf analoge Weise über Spannungspegel, auf digitale Weise über die Zeitdauer von Impulsen oder mit einem Busübertragungsprotokoll über Dateneinheiten in einem Datenbustelegramm erfolgt.

12. Verfahren nach Anspruch 11,
ferner **gekennzeichnet durch** den Schritt:
Senden zumindest eines Konfigurationsbefehls über eine elektrische Schnittstelle an das zweite Koppelelement, wodurch dieses konfiguriert wird.

13. Verfahren nach mindestens einem der Ansprüche 9 bis 12, ferner **gekennzeichnet durch** die Schritte:
Abfragen der Identifikation einer elektrischen Schnittstelle eines dritten Koppelelements, wenn dieses mit dem zweiten Koppelelement, welches mit dem ersten Koppelelement gekoppelt ist, gekoppelt wird, über eine elektrische Schnittstelle des zweiten Koppelelements; und
Empfangen der Identifikation der abgefragten Schnittstelle des dritten Koppelelements über die elektrische Schnittstelle des zweiten Koppelelements.

14. Verfahren nach Anspruch 13,
ferner **gekennzeichnet durch** den Schritt:
Senden zumindest eines Konfigurationsbefehls über die elektrische Schnittstelle des zweiten Koppelelements an das dritte Koppelelement, wodurch dieses konfiguriert wird.

## Geänderte Patentansprüche

### Geänderte Patentansprüche gemäss Regel 137(2) EPÜ.

**1.** Elektrische Koppelverbindung mit zwei Koppelelementen zum Herstellen einer elektrischen Verbindung zwischen diesen beiden Koppelelementen, wobei an jedem Koppelelement eine Stirnseite mit mindestens zwei punktsymmetrisch angeordneten elektrischen Schnittstellen vorgesehen ist,
**dadurch gekennzeichnet, dass**
die Stirnseiten der Koppelelemente mechanisch identisch sind und eines der Koppelelemente ein Mittel aufweist, welches eingerichtet ist, um die Ausrichtung des zweiten Koppelelements beim Herstellen einer elektrischen Verbindung mit dem Koppelelement über eine der elektrischen Schnittstellen zu erkennen.

**2.** Koppelverbindung nach Anspruch 1,
**dadurch gekennzeichnet, dass**
für jede elektrische Schnittstelle jedes Koppelelements ein Identifikationsmittel vorgesehen ist, welches eingerichtet ist, um die zugehörige elektrische Schnittstelle innerhalb des Koppelelements eindeutig zu identifizieren.

**3.** Koppelverbindung nach Anspruch 2,
**dadurch gekennzeichnet, dass**
das Identifikationsmittel eingerichtet ist, um die elektrische Schnittstelle auf analoge Weise über Spannungspegel zu identifizieren.

**4.** Koppelverbindung nach Anspruch 2,
**dadurch gekennzeichnet, dass**
das Identifikationsmittel eingerichtet ist, um die elektrische Schnittstelle auf digitale Weise über die Zeitdauer von Impulsen zu identifizieren.

**5.** Koppelverbindung nach Anspruch 2,
**dadurch gekennzeichnet, dass**
das Identifikationsmittel eingerichtet ist, um die elektrische Schnittstelle mit einem Busübertragungsprotokoll über Dateneinheiten in einem Datenbustelegramm zu identifizieren.

**6.** Koppelverbindung nach mindestens einem der vorherigen Ansprüche,
**dadurch gekennzeichnet, dass**
das Mittel, welches eingerichtet ist, um die Ausrichtung des zweiten Koppelelements beim Herstellen einer elektrischen Verbindung mit dem Koppelelement über eine der elektrischen Schnittstellen zu erkennen, ferner eingerichtet ist, um mindestens einen Konfigurationsbefehl zur Konfiguration des zweiten Koppelelements an dieses zu senden.

**7.** Koppelverbindung nach mindestens einem der vorherigen Ansprüche,
**dadurch gekennzeichnet, dass**
das Mittel, welches eingerichtet ist, um die Ausrichtung des zweiten Koppelelements beim Herstellen einer elektrischen Verbindung mit dem Koppelelement über eine der elektrischen Schnittstellen zu erkennen, ferner eingerichtet ist, um eine Schnittstelle eines dritten Koppelelements bei einer Kopplung mit dem zweiten Koppelelement abzufragen und dieses ggf. zu konfigurieren.

**8.** Koppelverbindung nach mindestens einem der vorherigen Ansprüche,
**dadurch gekennzeichnet, dass**
an jedem Koppelelement zwei Stirnseiten mit jeweils mindestens zwei punktsymmetrisch angeordneten elektrischen Schnittstellen vorgesehen sind.

**9.** Verfahren zum Koppeln eines ersten elektrischen Koppelelements mit einem zweiten Koppelelement, welche jeweils eine Stirnseite und mindestens zwei punktsymmetrisch an der Stirnseite angeordnete elektrische Schnittstellen aufweisen, wobei die Stirnseiten der Koppelelemente mechanisch identisch sind, mit den Schritten:
elektrisches Verbinden des ersten Koppelelements mit dem zweiten Koppelelement;
Abfragen einer Identifikation einer elektrischen Schnittstelle des zweiten Koppelelements über eine elektrische Schnittstelle des ersten Koppelelements; und
Empfangen der Identifikation der abgefragten Schnittstelle des zweiten Koppelelements über die elektrische Schnittstelle des ersten Koppelelements.

**10.** Verfahren nach Anspruch 9,
ferner **gekennzeichnet durch** den Schritt:
Ermitteln der Ausrichtung des zweiten Koppelelements relativ zu dem ersten Koppelelement aus der empfangenen Identifikation der abgefragten Schnittstelle des zweiten Koppelelements.

**11.** Verfahren nach Anspruch 9,
**dadurch gekennzeichnet, dass**
das Abfragen der Identifikation einer elektrischen Schnittstelle des zweiten Koppelelements auf analoge Weise über Spannungspegel, auf digitale Weise über die Zeitdauer von Impulsen oder mit einem Busübertragungsprotokoll über Dateneinheiten in einem Datenbustelegramm erfolgt.

**12.** Verfahren nach Anspruch 11,
ferner **gekennzeichnet durch** den Schritt:
Senden zumindest eines Konfigurationsbefehls über eine elektrische Schnittstelle an das zweite Koppelelement, wodurch dieses konfiguriert wird.

**13.** Verfahren nach mindestens einem der Ansprüche 9 bis 12,
ferner **gekennzeichnet durch** die Schritte:
Abfragen der Identifikation einer elektrischen Schnittstelle eines dritten Koppelelements, wenn dieses mit dem zweiten Koppelelement, welches mit dem ersten Koppelelement gekoppelt ist, gekoppelt wird, über eine elektrische Schnittstelle des zweiten Koppelelements; und
Empfangen der Identifikation der abgefragten Schnittstelle des dritten Koppelelements über die elektrische Schnittstelle des zweiten Koppelelements.

**14.** Verfahren nach Anspruch 13,
ferner **gekennzeichnet durch** den Schritt:
Senden zumindest eines Konfigurationsbefehls über die elektrische Schnittstelle des zweiten Koppelelements an das dritte Koppelelement, wodurch dieses konfiguriert wird.
